# EUROPEAN PATENT APPLICATION

(11) **EP 4 614 548 A1**
(43) Date of publication of application: **10.09.2025**
(21) Application number: 24162324.8
(22) Date of filing: 08.03.2024
(51) Int. Cl.: H01L 21/20

(54) **A SEMICONDUCTOR STRUCTURE WITH STRAINED BOTTOM LAYER**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

The present invention relates to a semiconductor structure, and a method for producing such structure. The structure comprises: a substrate being a silicon substrate; a bottom layer, being a layer of AIN arranged on the substrate; a first stack of layers arranged above the bottom layer, the first stack of layers comprising alternating AIN layers and GaN layers; wherein the first stack of layers comprises: a first GaN layer, facing the bottom layer; a first AIN layer, arranged on the first GaN layer; a second GaN layer, arranged on the first AIN layer; wherein the bottom layer has a thickness between 100 and 800 nm; wherein the first AIN layer is thinner than the respective first and second GaN layers ; and wherein both the bottom layer and the first AIN layer is configured to be under compressive stress.

## Description

### Technical field

The present invention relates to a semiconductor structures comprising GaN on a silicon substrate, and methods of depositing such structures.

### Background

A challenge in growth of GaN-on-Silicon is curvature control. Due to the thermal mismatch of GaN on Silicon, which is 53% at 1000°C, the silicon wafer tends to bow during growth going from a non-significant bow to a positive curvature then the wafer tends towards a negative curvature. Due to non-elastic behavior the wafer may have a residual curvature after cooldown to room-temperature.

### Summary of the invention

An object of the present invention is to facilitate growth of nitride structures on silicon. In particular, it is an object to facilitate growth of GaN structures on silicon. It is an object to facilitate growth of high-quality nitride structures on silicon. In particular, it is an object to facilitate growth of nitride structures on silicon with high curvature control. In particular, it is an object to facilitate growth of nitride structures with few or no dislocations. It is an object to facilitate cheap and/or easy production of nitride structures on silicon.

According to a first aspect of the present invention, a semiconductor structure is provided. The semiconductor structure comprising: a substrate being a silicon substrate; a bottom layer, being a layer of AIN arranged on the substrate; a first stack of layers arranged above the bottom layer. The first stack of layers comprising alternating AIN layers and GaN layers. The first stack of layers comprises: a first GaN layer, facing the bottom layer; a first AIN layer, arranged on the first GaN layer; a second GaN layer, arranged on the first AIN layer. The bottom layer has a thickness between 100 and 800 nm. The first AIN layer is thinner than the respective first and second GaN layers.

The atomic structure of the bottom layer, preferably the whole bottom layer, is under compressive stress. Further, the atomic structure of the first AIN layer, preferably the whole bottom layer, is under compressive stress.

It should be noted that a *"bottom layer"* may also be referred to as a *"primer layer".* That is, the bottom layer is the first layer that is deposited on the substrate. Further, it should be noted that a *"stack of layers"* may also be referred to as a *"superlattice".* The first stack of layers, or the first superlattice, together with the bottom layer, or the primer layer, may jointly be referred to as, or constitute a portion of, a *"buffer layer".*

The inventor has realized that a primer layer, which is the first layer deposited on the silicon wafer, of AIN is advantageous. However, when depositing GaN on the AIN primer layer, the in-plane stress may be tensile. In order to further build enough compression to obtain a flat wafer, several interlayers may be introduced.

The inventor has realized that instead of using a metalorganic chemical vapor deposition (MOCVD) AIN primer layer, preferably using a plasma assisted or magnetron sputtered AIN layer that is more compressive than MOCVD AIN, improves strain layer management of GaN-on-Si. That is, the benefit of the invention is that it can alleviate the poor compression of MOCVD AIN by using a sputtered AIN layer. It is a realization that when using sputtered AIN as a bottom layer, the compressive stress of the bottom layer may be high. Thus, a relatively thin bottom layer may be used. Further, relatively thin layers of the first stack of layers may be used. Thus, the entire buffer layer may be thin. Further, variations in stress may be smaller than in conventional technology. Thus, the semiconductor structure may have a small wafer warp and/or bow. Thus, a high curvature control is facilitated. The use of layers which may be thinner than in conventional technology saves material and time in production. This may in turn result in a low production cost.

Further, it is a realization that it may be beneficial with high compressive stress at a lower part of the buffer layer. This may prevent the crack formation in the buffer layer and/or in the device layer on top of the buffer layer at cooldown after growth.

Further, it is a realization that a semiconductor structure according to the invention has a uniform stress distribution over the substrate, e.g. a radially uniform stress distribution. This may facilitate growth on a large substrate which may later be divided into smaller pieces, wherein the smaller pieces have similar stress properties.

The compressive stress of a layer, e.g. the bottom layer or the second stack layer may be measured using a laser light source to scan the surface of the wafer in order to measure the radius of curvature. The stresses discussed herein refer to stresses measured at room temperature. The compressive stress of the bottom layer may be between 1 and 3 GPa.

The bottom layer is preferably obtained by sputtering. The sputtering may be plasma assisted sputtering or magnetron sputtering. The thickness of the bottom layer may be between 150 and 250 nm. Said thicknesses may be sufficient to build an adequate amount of compressive stress, e.g. an adequate amount of compressive stress for achieving a relatively small bow and/or warp. Said thicknesses may be small enough to facilitate a surface roughness of below 7 nm, preferably below 5 nm. The bottom layer may be thinner than at least one of the first and third stack layers. For example, the bottom layer may be thinner than the first and third stack layers, respectively. Hence, the bottom layer may have a roughness of below 7 nm, preferably below 5 nm. The roughness may be measured as a Rq value or a root mean square value (RMS). The roughness may be measured by e.g. atomic force microscopy or a surface profiler. A small surface roughness may facilitate good quality of the layers above, e.g. layers grown above the buffer layer, i.e. layers grown above the stack of layers. For example, a heterostructure (e.g. a GaN/AIGaN heterostructure) may be grown above the stack of layers to form a two-dimensional electron gas (2DEG). The interface of such a heterostructure is preferably to be atomically smooth with an RMS value below 0.25 nm. In such a case, the roughness of the bottom layer may affect the roughness of the interface of the heterostructure.

The thickness of the respective AIN layers of the first stack of layers may be between 15 and 25 nm. The thickness of the first GaN layer of the first stack of layers may be between 200 and 400 nm and the thickness of the second GaN layer of the first stack of layers may be between 400 and 500 nm. The above thicknesses of the first stack of layers are advantageous to achieve strain layer management and at the same time avoid formation of dislocations.

The bottom layer may be more than a factor 8 and less than a factor 20 thicker than at least one of the first and second AIN layers. The bottom layer may have a thickness between 150 and 250 nm and be less than a factor 20 thicker than the first stack layer. As an example, the bottom layer may e.g. have a thickness of 200 nm, whereas at least one of the first and second AIN layers have a thickness of 16 nm.

The semiconductor device may further comprise a second stack of layers arranged between the bottom layer and the first stack of layers. The second stack of layers comprises alternating AIN layers and GaN layers. The AIN layers of the second stack of layers preferably have a thickness below 6 nm. The AIN layers of the second stack of layers are preferably thicker than the GaN layers of the second stack of layers.

The layers of the second stack of layers may be thinner than the layers of the first stack of layers. The layers of the second stack of layers may distribute the stress at the transition from the compressively stressed bottom layer to the first stack of layers such that bow and/or warp is minimized. For example, the thickness of the layers of AIN of the second stack of layers may be between 4 and 6 nm and the thickness of layers of GaN of the second stack of layers may be between 2 and 4 nm.

A top surface of the silicon substrate may have Miller indices {1,1,1}, the top surface of the silicon substrate may herein be flat. Thus, the silicon substrate may be a Si(111) substrate.

Alternatively, a top surface of the silicon substrate may have Miller indices {1,0,0}; wherein the substrate comprises a plurality of recesses, each recess having at least one side facet with Miller indices {1,1,1}; wherein the bottom layer fills the recesses. Thus, the silicon substrate may be a Si(100) substrate comprising recesses.

The first stack of layers may further comprise: a second AIN layer, arranged on the second GaN layer; a third GaN layer, arranged on the second AIN layer; a third AIN layer, arranged on the third GaN layer; a fourth GaN layer, arranged on the third AIN layer; a fourth AIN layer, arranged on the fourth GaN layer; and a fifth GaN layer, arranged on the fourth AIN layer.

The thickness of the first GaN layer of the first stack of layers may be between 200 and 400 nm. The thickness of the second, third and fourth GaN layers may be between 400 and 600 nm. The thickness of the fifth GaN layer may be between 1100 nm and 1500 nm.

According to a second aspect of the present invention, a method for producing the semiconductor structure according to the first aspect is provided, the method comprising: forming, by sputtering, a bottom layer of AIN on a silicon substrate,; forming a first stack of layers above the bottom layer, the first stack of layers comprising alternating AIN layers and GaN layers, wherein the GaN layers of the first stack of layers are thicker than the AIN layers of the first stack of layers. The first stack of layers comprises: a first GaN layer, facing the bottom layer; a first AIN layer, arranged on the first GaN layer; a second GaN layer, arranged on the first AIN layer. The bottom layer has a thickness between 100 and 800 nm. As a result the atomic structure of the bottom layer is under compressive stress. As a result the atomic structure of the first AIN layer is under compressive stress.

In general, features of this aspect of the invention provide similar advantages as discussed above in relation to the first aspect of the invention. Consequently, said advantages will not be repeated in order to avoid undue repetition. Hence, the details and advantages of this aspect of the invention are largely analogous to those of the first aspect of the invention, wherein reference is made to the above.

At least part of the bottom layer may be formed by sputtering at a temperature of at least 700°C. Sputtered AIN at such a temperature may build an adequate amount of compressive stress.

The bottom layer may comprise a first sublayer of AIN and a second sublayer of AIN, wherein the first sublayer is formed by sputtering at a temperature above 750°C and the second sublayer is formed by sputtering at a temperature below 750°C. Such a two-temperature sputtering may build an adequate amount of compressive stress with high crystalline quality, FWHM(002) <1°. Further, the stress may be uniformly distributed over the substrate. Further, a top surface of the bottom layer may be adequately smooth. The first sublayer of the bottom layer may have a thickness of 10-100 nm and the second sublayer of the bottom layer may have a thickness of 100-500 nm. In particular, the first sublayer of the bottom layer may have a thickness of 100 nm and the second sublayer of the bottom layer may have a thickness of 300 nm. Said thicknesses may optimize the amount of stress, the distribution of stress over the substrate, and the roughness of the bottom layer.

A top surface of the silicon substrate may have Miller indices {1 ,0,0}; wherein the method may further comprise forming a plurality of recesses in the silicon substrate such that each recess has at least one side facet with Miller indices {1,1,1}; wherein the bottom layer may be formed such that the recesses are filled with the bottom layer. The recesses may, e.g., be provided by etching or milling.

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only, and is not intended to be limiting.

It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief description of the drawings

The above and other aspects of the present invention will, in the following, be described in more detail with reference to appended figures. The figures should not be considered limiting; instead they should be considered for explaining and understanding purposes.

As illustrated in the figures, the sizes of layers and regions may be exaggerated for illustrative purposes and, thus, are provided to illustrate the general structures. Like reference numerals refer to like elements throughout.
Fig. 1A is a schematic view of a semiconductor structure, wherein the substrate is Si (100);
Fig. 1B is a schematic view of the semiconductor structure of Fig. 1A, further comprising a second stack of layers;
Fig. 2 is a schematic view of a semiconductor structure, wherein the surface of the substrate is provided with recesses, each recess having at least one side facet with Miller indices {1,1,1};
Figs. 3A-3E schematically depicts deposition of compressive sputtered AIN on patterned silicon substrates exposing <111 > faces of silicon;
Fig. 4 is a flow chart showing the method of producing a semiconductor structure.

### Detailed description

In the following detailed description, some embodiments of the present invention will be described. However, it is to be understood that features of the different embodiments are exchangeable between the embodiments and may be combined in different ways, unless anything is specifically indicated. Even though in the following description, numerous details are set forth to provide a more thorough understanding of the present invention, it will be apparent to one skilled in the art that the present invention may be practiced without these details. In other instances, well known constructions or functions are not described in detail, so as not to obscure the present invention. In the drawings, similar or corresponding features are indicated by the same reference number.

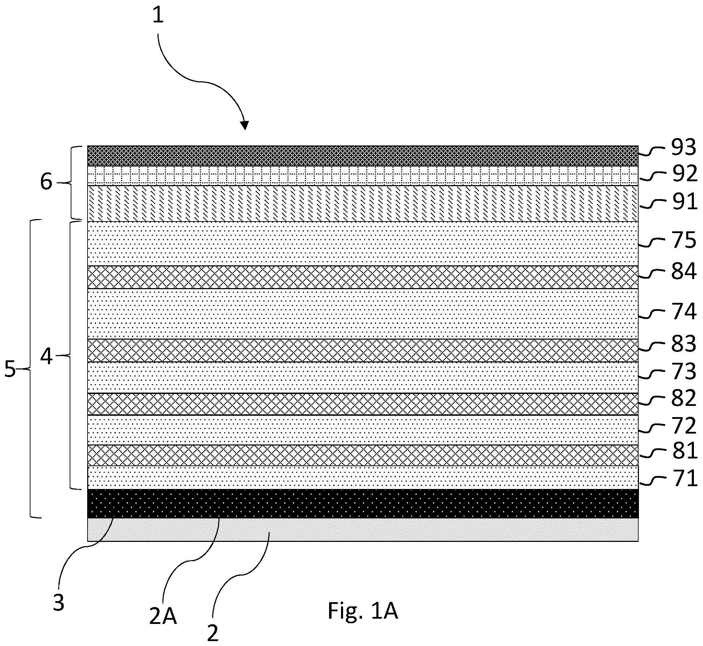

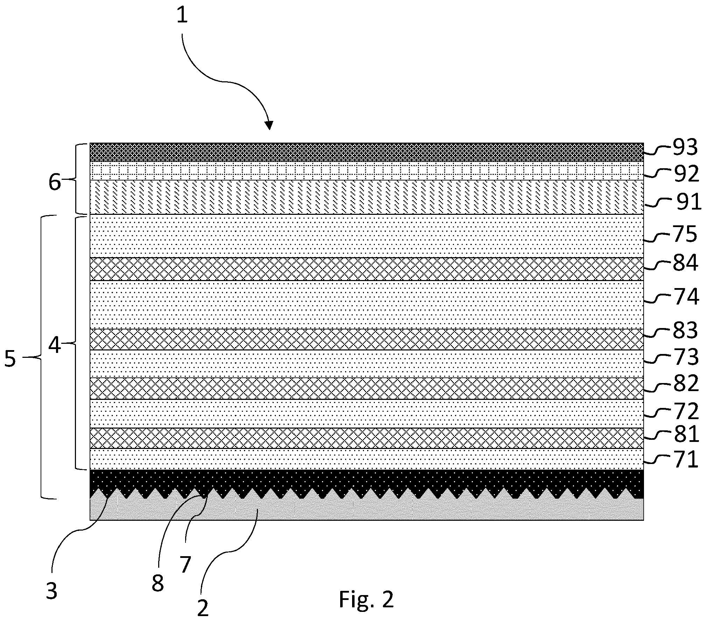

In Fig. 1A, a schematic view of a semiconductor structure 1 is shown. The semiconductor structure 1 comprises a substrate 2, the substrate 2 being a silicon substrate. Here, the substrate has a flat top surface. Here, the top surface 2A of the substrate 2 has miller indices {1,1,1 }. Thus, the substrate may be a Si(111) substrate. However, as is shown in Fig. 2, the substrate 2 may be provided with recesses 7. In Fig. 2, the substrate 2 may have a top surface 2A having miller indices {1,0,0}, i.e. the substrate 2 may be a Si(100) substrate, wherein the substrate 2 is provided with recesses 7 such that at least one facet 8 of each recess 7 has a surface with miller indices {1,1,1 }.

The semiconductor structure 1 comprises a bottom layer 3. The bottom layer 3 is a layer of AIN arranged on the substrate. The bottom layer 3 has a thickness between 100 and 800 nm, preferably between 150 and 250 nm. For example, the bottom layer 3 may have a thickness of 200 nm. The bottom layer may further have a surface roughness of below 7 nm, preferably below 5 nm. The bottom layer 3 may be deposited on the substrate 2 by means of plasma assisted sputtering, or magnetron sputtering. It is a realization that sputtered AIN may be more compressive than AIN grown by MOCVD. The stress of a layer may depend on the nominal lattice constant of the material in the layer, the lattice constants of adjacent layers, the stress of adjacent layers. The stress of a layer may further depend on the crystal structure of the layer, e.g. on the amount of dislocations, the type of dislocations, the crystallinity of the layer, the amount of grain boundaries in the layer, the distribution of grain boundaries in the layer. It is a realization that the stress of a layer may be controlled by the sputtering parameters.

At least part of the bottom layer may be formed by sputtering at a temperature of at least 700°C. For example, the process gas composition may comprise argon, and wherein a rataio of nitrogen to argon is in the range of 1:1 to 1:3. A total pressure in the process chamber during sputtering may be less than 7.5 mTorr (1 Pa). Hereby, the rate of ionization of the process gas composition increases. Thus, the rate of sputtering, and therefore the rate of deposition of the aluminum and nitrogen increases. Alternatively, the partial pressures of aluminum and argon, p_{Ar}, and nitrogen, p_{N2}, in the plasma formed in the process chamber may be in the range 0.1 mTorr < p_{Ar} < 3 mTorr whereas the partial pressure of nitrogen, may be in the range 0.2 < p_{N2} < 0.3 mTorr. The bottom AIN layer may be formed without RF bias, and the top layer with 200W RF power with positive chuck bias. Sputtering the aluminum target while applying a positive bias on the silicon substrate may be used with positive bias in the range 1-5 kV.

Sputtered AIN at such a temperature may build an adequate amount of compressive stress. The bottom layer may comprise a first sublayer of AlN and a second sublayer of AIN, wherein the first sublayer is formed by sputtering at a temperature above 750°C and the second sublayer is formed by sputtering at a temperature below 750°C. Such a two-temperature sputtering may build an adequate amount of compressive stress. Further, the stress may be uniformly distributed over the substrate. Further, a top surface of the bottom layer may be adequately smooth. The first sublayer of the bottom layer may have a thickness of 10-100 nm and the second sublayer of the bottom layer may have a thickness of 100-500 nm. In particular, the first sublayer of the bottom layer may have a thickness of 100 nm and the second sublayer of the bottom layer may have a thickness of 300 nm. Said thicknesses may optimize the amount of stress, the distribution of stress over the substrate, and the roughness of the bottom layer. Sputtering of AIN onto a silicon surface is discussed in more detail in the application PCT/EP2024/051638 by the same applicant as this application. The content of PCT/EP2024/051638 is included herein by reference.

The semiconductor structure 1 further comprises a first stack 4 of layers arranged above the bottom layer 3. The first stack 4 of layers comprises alternating AIN layers and GaN layers.

The first stack 4 of layers comprises: a first GaN layer 71 facing the bottom layer 3, and a first AIN layer 81 arranged on the first GaN layer 71. Further, the stack 4 comprises a second GaN layer 72 arranged on the first AIN layer 81.

Furthermore, the stack 4 may comprise:
a second AIN layer 82, arranged on the second GaN layer 72;
a third GaN layer 73, arranged on the second AIN layer 82;
a third AIN layer 83, arranged on the third GaN layer 73;
a fourth GaN layer 74, arranged on the third AIN layer 83;
a fourth AIN layer 84, arranged on the fourth GaN layer 74;
a fifth GaN 75 layer, arranged on the fourth AIN layer 84.

It is to be understood that the first stack 4 of layers may comprise any number of layers suitable for any specific object or application of the semiconductor structure. The thickness of any one layer of the stack 4 of layers may vary with regards to the other layers. The first AIN layer 81 is preferably thinner than the respective first and second GaN layers 71, 72. The thickness of the respective AIN layers 81, 82, 83, 84 of the first stack 4 of layers may, e.g., be between 15 and 25 nm. The thickness of the respective GaN layers 71, 72, 73, 74 of the first stack 4 of layers may, e.g., be between 200 nm and 600 nm. Additionally, or alternatively, the thickness of the first GaN layer 71 of the first stack 4 of layers may be between 200 and 400 nm, whereas the thickness of the second, third and fourth GaN layers 72, 73, 74 of the first stack 4 of layers may be between 400 and 600 nm, respectively, and wherein the thickness of the fifth GaN layer 75 may be between 1100 nm and 1500 nm.

The bottom layer 3 may be thinner than at least one of the GaN layers 71, 72, 73, 74 of the first stack 4 of layers. Further, the bottom layer 3 may be thicker than at least one of the first and second AIN layers 81, 82 of the first stack 4 of layers. For example, the bottom layer 3 may be more than a factor 8 and less than a factor 20 thicker than at least one of the first and second AIN layers 81, 82. In particular, the bottom layer 3 may have a thickness between 150 and 250 nm and be less than a factor 20 thicker than the first stack layer. For example, the bottom layer 3 may e.g. have a thickness of 200 nm, whereas at least one of the first and second AIN layers 81, 82 have a thickness of 16 nm.

Both the bottom layer 3 and the first AIN layer of the stack 4 are under compressive stress. Typically, the whole layer is under compressive stress. The compressive stress of the bottom layer 3 may be between 1 and 3 GPa. The compressive stress of may be measured using a laser light source to scan the surface of the wafer in order to measure the radius of curvature. Alternatively, or in combination the compressive stress may be measured by X-ray diffraction (XRD), e.g. by high resolution x-ray diffraction (HRXRD). The compressive stress of a layer may e.g. be measured in a XRD reciprocal space map. The compressive stresses discussed herein refer to compressive stresses measured at room temperature.

The bottom layer 3 and the first stack 4 of layers may constitute, or be parts of, a buffer layer 5. The buffer layer 5 may serve as an interface between the substrate 2 and a device layer 6. The device layer 6 may comprise any layer or combination of layers suitable for any specific object or application of the semiconductor structure 1. The device layer 6 may e.g. comprise a GaN layer 91, doped or undoped (undoped being advantageous for 2DEG formation), and an AlGaN barrier layer 92 deposited thereon, such that a two-dimensional electron gas is formed at an interface between the GaN layer 91 and the AlGaN layer 92. The AlGaN layer 92 may, e.g., have the composition AI(0.27)Ga(0.73)N. However, the AlGaN layer 92 may have any other composition. The device layer 6 may further comprise a GaN cap layer 93 arranged on the AlGaN barrier layer 92, e.g. an n-doped GaN cap layer 93. The buffer layer 5 may reduce or prevent wafer bow. The buffer layer 5 may reduce or prevent stress in the device layer 6. The buffer layer 5 may reduce or prevent dislocations in the device layer 6.

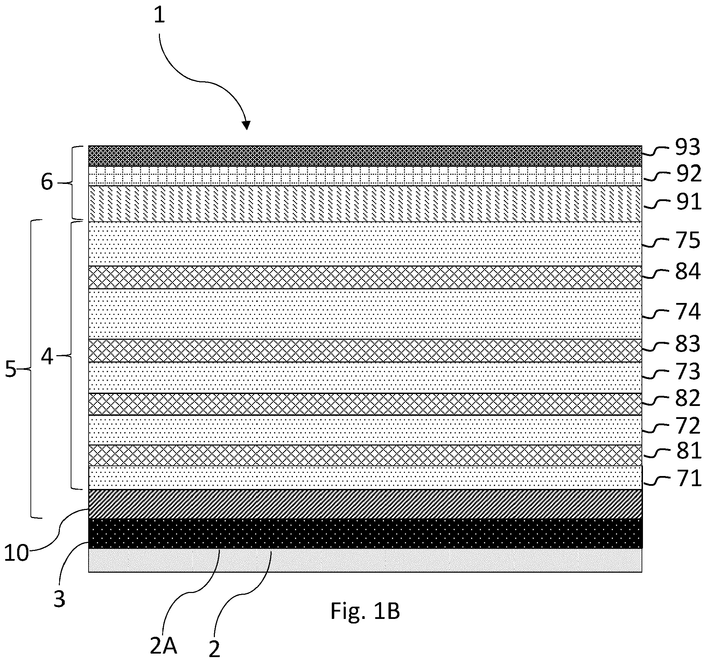

As is illustrated in Fig. 1B, the semiconductor device 1 may further comprise a second stack 10 of layers arranged between the bottom layer 3 and the first stack 4 of layers. The second stack of layers comprises alternating AIN layers and GaN layers. The AIN layers of the second stack 10 of layers may have a thickness below 6 nm. The AIN layers of the second stack 10 of layers may be thicker than the GaN layers of the second stack 10 of layers. For example, the thickness of the layers of AIN of the second stack 10 of layers may be between 4 and 6 nm and the thickness of layers of GaN of the second stack 10 of layers may be between 2 and 4 nm. The second stack 10 of layers may, e.g., comprise 3 layers of AIN and 3 layers of GaN.

In Fig. 2, a schematic view of another semiconductor structure 1 is shown. The substrate 2 is here a Si(100) substrate. The top surface 2A of the substrate is provided with a plurality of recesses 7, each recess 7 having at least one side facet 8 with Miller indices {1,1,1}. As can be seen, the bottom layer 3 fills the recesses 7. Hereby, a substantially flat and/or even bottom layer 3, akin to that shown in Fig. 1, is formed. Hence, the substrate 2 and the bottom layer 3 is provided with the same layers as has been discussed in relation to Fig. 1A, which will not be repeated here in order to avoid undue repetition.

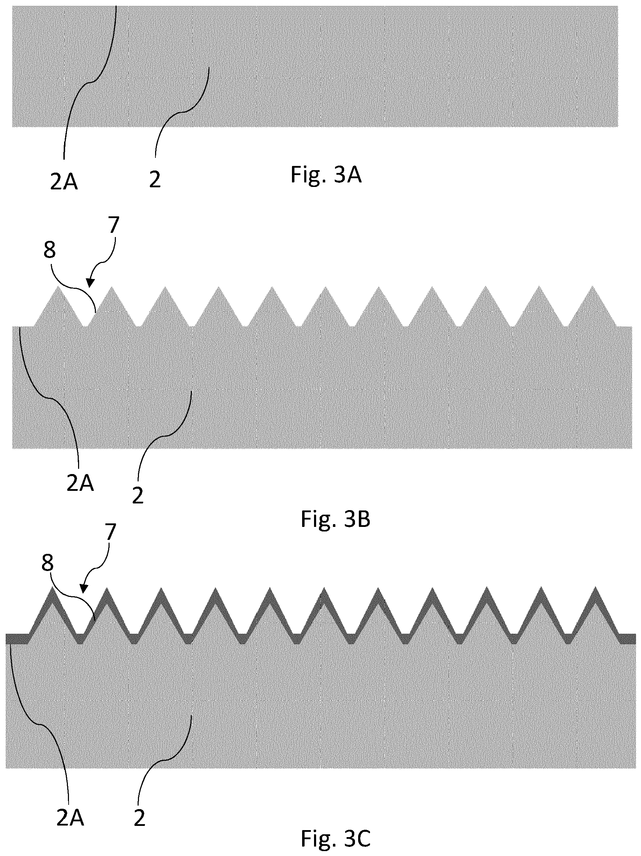

The process of providing the top surface 2A of the substrate 2 with recesses and the provision of the bottom layer 3 is shown in Figs. 3A-3E.

In Fig. 3A, a substrate 2 having a top surface 2A is provided.

In Fig. 3B, the substrate 2 has been provided with recesses 7 having at least one side facet 8 with Miller indices {1,1,1}. The recesses 7 may e.g. be provided by etching, such as wet etching, or milling, such as electron beam milling.

In Fig. 3C, a thin layer of AIN has been provided over the top surface 2A and the recesses 7 thereof.

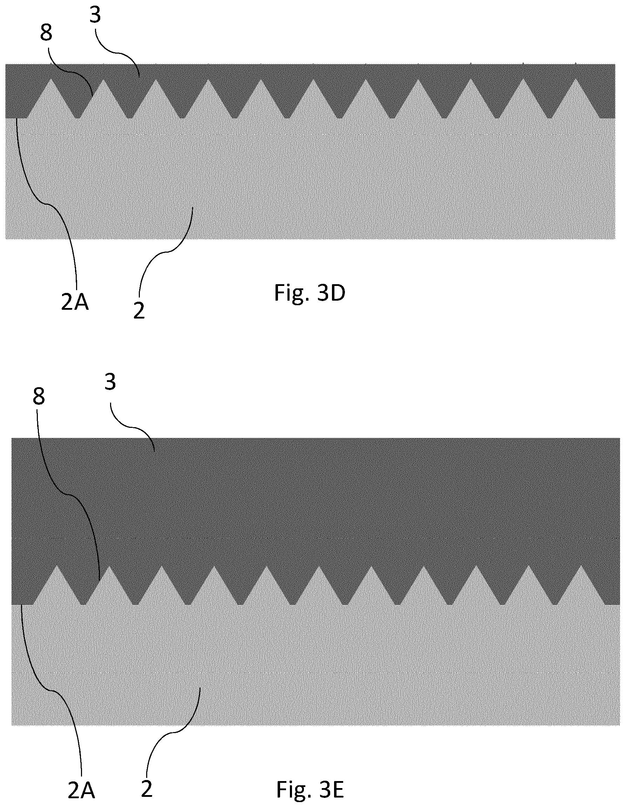

In Fig. 3D, the recesses 7 have been filled with AIN such that a bottom layer 3 has been formed.

In Fig. 3E, the bottom layer 3 has been increased to a desired thickness, such as between 150 and 250 nm.

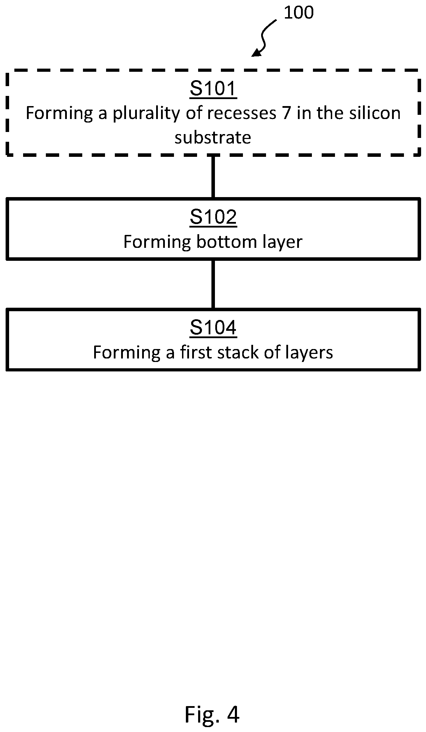

In Fig. 4, a flow chart showing a method 100 of producing a semiconductor structure 1 is shown.

The method comprises forming S102 a bottom layer 3 of AIN on a substrate 2. The forming of the bottom layer 3 of AIN on a substrate 2 is performed by sputtering. The sputtering may e.g. be performed by plasma assisted sputtering or magnetron sputtering.

At least part of the bottom layer may be formed by sputtering at a temperature of at least 700°C. Sputtered AIN at such a temperature may build an adequate amount of compressive stress.

The bottom layer may comprise a first sublayer of AIN and a second sublayer of AIN, wherein the first sublayer is formed by sputtering at a temperature above 750°C and the second sublayer is formed by sputtering at a temperature below 750°C. Such a two-temperature sputtering may build an adequate amount of compressive stress. Further, the stress may be uniformly distributed over the substrate. Further, a top surface of the bottom layer may be adequately smooth.

The first sublayer of the bottom layer may have a thickness of 10-100 nm and the second sublayer of the bottom layer may have a thickness of 100-500 nm.

In particular, the first sublayer may be formed by sputtering 100 nm AIN at 780°C. The second sublayer may be formed by sputtering 300 nm AIN at 720°C.

The method 100 further comprises forming S104 a first stack 4 of layers above the bottom layer 3, the first stack 4 of layers comprising alternating AIN layers and GaN layers, wherein the GaN layers of the first stack 4 of layers are thicker than the AIN layers of the first stack 4 of layers. The first stack 4 of layers comprises: a first GaN layer 71, facing the bottom layer 3, a first AIN layer 81, arranged on the first GaN layer 71, a second GaN layer 72, arranged on the first AIN layer 81, wherein the bottom layer 3 has a thickness between 100 and 800 nm. As a result, the atomic structure of the bottom layer 3 is under compressive stress and the atomic structure of the first AIN layer 81 is under compressive stress.

The top surface 2A of the silicon substrate 2 may have Miller indices {1,0,0}, wherein the method 100 further comprises forming S101 a plurality of recesses 7 in the silicon substrate 2 such that each recess 7 has at least one side facet 8 with Miller indices {1,1,1}; wherein the bottom layer 3 is formed such that the recesses 7 are filled with the bottom layer 3.

Although modifications and changes may be suggested by those skilled in the art, it is the intent of the inventor to, within the scope of the disclosure herein, that the invention encompasses the scope of all modifications and modifications which reasonably and properly fall within the scope of the disclosure disclosed herein. The present invention has been described above with reference to specific embodiments. However, other embodiments than the above described are equally possible within the scope of the invention. The different features and steps of the invention may be combined in other combinations than those described. For example, various features of embodiments may be combined in combinations other than those described mutatis mutandis. The scope of the invention is limited only by the appended claims.

## Claims

1. A semiconductor structure (1) comprising:
a substrate (2) being a silicon substrate;
a bottom layer (3), being a layer of AIN arranged on the substrate (2);
a first stack (4) of layers arranged above the bottom layer (3), the first stack (4) of layers comprising alternating AIN layers and GaN layers, wherein the first stack (4) of layers comprises:
a first GaN layer (71), facing the bottom layer (3),
a first AIN layer (81), arranged on the first GaN layer (71), and
a second GaN layer (72), arranged on the first AIN layer (81);
wherein the bottom layer (3) has a thickness between 100 and 800 nm;
and
wherein the first AIN layer (81) is thinner than the respective first (71)
and second GaN layers (72).

2. The semiconductor structure (1) according to claim 1, wherein the atomic structure of the bottom layer (3) is under compressive stress, wherein the atomic structure of the first AIN layer (81) is under compressive stress, wherein the compressive stress of the bottom layer (3) is between 1 and 3 GPa.

3. The semiconductor structure (1) according to claim 1 or 2, wherein the thickness of the bottom layer (3) is between 150 and 250 nm.

4. The semiconductor structure (1) according to any one of claims 1-3, wherein the thickness of the respective AIN layers of the first stack (4) of layers is between 15 and 25 nm.

5. The semiconductor structure (1) according to any one of claims 1-4, wherein the thickness of the first GaN layer (71) of the first stack (4) of layers is between 200 and 400 nm and the thickness of the second GaN layer (72) of the first stack (4) of layers is between 400 and 500 nm.

6. The semiconductor structure (1) according to any one of claims 1-5, wherein the bottom layer (3) is more than a factor 8 and less than a factor 20 thicker than at least one of the first and second AIN layers (81).

7. The semiconductor structure (1) according to any one of claims 1-6, wherein the semiconductor structure further comprises a second stack (10) of layers arranged between the bottom layer (3) and the first stack (4) of layers, wherein the second stack (10) of layers comprises alternating AIN layers and GaN layers, wherein the AIN layers of the second stack (10) of layers have a thickness below 6 nm; wherein the AIN layers of the second stack (10) of layers are thicker than the GaN layers of the second stack of layers (10).

8. The semiconductor structure (1) according to claim 7, wherein the thickness of the layers of AIN of the second stack (10) of layers is between 4 and 6 nm and the thickness of layers of GaN of the second stack (10) of layers is between 2 and 4 nm.

9. The semiconductor structure (1) according to any one of claims 1-8, wherein a top surface (2A) of the silicon substrate has Miller indices {1,0,0}; wherein the substrate (2) comprises a plurality of recesses (7), each recess (7) having at least one side facet (8) with Miller indices {1,1,1}; wherein the bottom layer (3) fills the recesses (7).

10. The semiconductor structure (1) according to any one of claims 1-9, wherein the first stack (4) of layers further comprises:
a second AIN layer, arranged on the second GaN layer;
a third GaN layer, arranged on the second AIN layer;
a third AIN layer, arranged on the third GaN layer;
a fourth GaN layer, arranged on the third AIN layer;
a fourth AIN layer, arranged on the fourth GaN layer; and
a fifth GaN layer, arranged on the fourth AIN layer;
wherein the thickness of the first GaN layer of the first stack (4) of layers is between 200 and 400 nm;
wherein the thickness of the second, third and fourth GaN layers (72, 73, 74) is between 400 and 600 nm; and
wherein the thickness of the fifth GaN layer (75) is between 1100 nm and 1500 nm.

11. The semiconductor structure (1) according to any one of claims 1-10, wherein the bottom layer (3) has a surface roughness of below 7 nm, preferably below 5 nm.

12. A method (100) for producing a semiconductor structure (1), the method (100) comprising:
forming (S102), by sputtering, a bottom layer (3) of AIN on a substrate (2) being a silicon substrate, wherein the bottom layer (3) has a thickness between 100 and 800 nm;
forming (S104) a first stack (4) of layers above the bottom layer (3), the first stack (4) of layers comprising alternating AIN layers and GaN layers, wherein the GaN layers of the first stack (4) of layers are thicker than the AIN layers of the first stack (4) of layers, wherein the first stack (4) of layers comprises:
a first GaN layer (71), facing the bottom layer (3),
a first AIN layer (81), arranged on the first GaN layer (71), and
a second GaN layer (72), arranged on the first AIN layer (81);
such that the atomic structure of the bottom layer (3) is under compressive stress; and
such that the atomic structure of the first AIN layer (81) is under compressive stress.

13. The method according to claim 12, wherein at least part of the bottom layer (3) is formed by sputtering at a temperature of at least 700°C.

14. The method according to claim 12 or 13,
wherein the bottom layer (3) comprises a first sublayer of AIN and a second sublayer of AIN, wherein the first sublayer is formed by sputtering at a temperature above 750°C and the second sublayer is formed by sputtering at a temperature below 750°C;
wherein the first sublayer has a thickness of 10-100 nm and the second sublayer has a thickness of 100-500 nm.

15. The method according to any one of claims 12-14, wherein a top surface (2A) of the silicon substrate (2) has Miller indices {1,0,0}; wherein the method further comprises forming (S101) a plurality of recesses (7) in the silicon substrate (2) such that each recess (7) has at least one side facet (8) with Miller indices {1,1,1}; wherein the bottom layer (3) is formed such that the recesses (7) are filled with the bottom layer (3).
